# EUROPÄISCHE PATENTSCHRIFT

(11) **EP 1 781 075 B1**
(45) Veröffentlichungstag und Bekanntmachung des Hinweises auf die Patenterteilung: **19.12.2007**
(21) Anmeldenummer: 05292136.8
(22) Anmeldetag: 12.10.2005
(51) Int. Cl.: H05K 7/20, B60K 1/00

(54) **Kühlvorrichtung für ein Kraftfahrzeug mit einem aus zwei Motoren bestehenden Antrieb**
Cooling device for motor vehicle with hybrid drive
Dispositif de refroidissement pour un véhicule à motorisation hybride

(43) Veröffentlichungstag der Anmeldung: 02.05.2007
(73) Patentinhaber: Nexans, 75008 Paris (FR); Bayerische Motoren Werke Aktiengesellschaft, 80788 München (DE)
(72) Erfinder: Steinberg, Helmut Dr.-Ing., 92721 Störnstein (DE); Hohenner, Hans, 80939 München (DE); Krauthan, Josef Dr., 95643 Tirschenreuth (DE); Mayer, Udo Dr., 92637 Weiden (DE); Hanebuth, Helmut, 92715 Püschersreuth (DE)
(74) Vertreter: Döring, Roger

(56) Entgegenhaltungen:
- EP-A- 1 227 006
- EP-A- 1 538 885
- WO-A-99/40768
- JP-A- 2002 016 386
- US-A1- 2004 094 115

## Beschreibung

Die Erfindung betrifft eine Kühlvorrichtung eines Kraftfahrzeugs mit einem aus zwei Motoren bestehenden Antrieb, von denen einer ein Verbrennungsmotor und der andere ein über elektrische Leitungen mit einem an eine elektrische Energiequelle angeschlossenen Wechselrichter verbundener Elektromotor ist, bei welcher im Innenraum des Kraftfahrzeugs Mittel zur Kühlung der Energiequelle und des Wechselrichters angeordnet sind (EP 1 538 885 A2).

Ein derartiges Kraftfahrzeug ist als "Hybrid-Auto" bekannt geworden. Es wird im folgenden auch so bezeichnet. Ein Hybrid-Auto ist mit zwei unterschiedlichen Motoren ausgerüstet, einem Verbrennungsmotor (Otto oder Diesel) und einem Elektromotor. In bekannter Technik kann wahlweise von einem Motor auf den anderen umgeschaltet werden. Beim Betrieb des Hybrid-Autos mit dem Elektromotor entstehen keine Abgase. Das ist besonders im Stadtbetrieb von Vorteil. Der Elektromotor wird aus einer entsprechend dimensionierten Energiequelle gespeist. Er kann auch so betrieben werden, daß er bei weiter arbeitendem Verbrennungsmotor eine Zusatzleistung erzeugt, so daß dann beide Motoren als Antrieb des Hybrid-Autos wirken. Diese Möglichkeit kann besonders bei Steigungen von Vorteil sein, aber auch bei Überholvorgängen.

Der Elektromotor ist in bekannter Technik ein Drehstrommotor, für dessen Betrieb durch einen ebenfalls im Hybrid-Auto untergebrachten Wechselrichter ein Wechselstrom erzeugt wird. Die Energiequelle ist beispielsweise ein aus einer Vielzahl von Kondensatoren (Ultracaps) bestehender Energiespeicher, der beispielsweise im Kofferraum eines Hybrid-Autos untergebracht sein kann. Die Kapazität der Kondensatoren reicht für einen kurzzeitigen Betrieb des Elektromotors aus. Sie werden beispielsweise während des Bremsbetriebs durch den dann als Generator wirkenden Elektromotor wieder aufgeladen. Zum Betrieb des Elektromotors ist derselbe mittels einer dreiadrigen elektrischen Leitung mit dem Wechselrichter verbunden, der seinerseits über eine andere elektrische Leitung mit dem Energiespeicher verbunden ist.

Bei der bekannten Kühlvorrichtung nach der eingangs erwähnten EP 1 538 885 A2 sind die Energiequelle und der Wechselrichter sowie ein Gleichstromwandler in konzentrierter Anordnung unter einem Sitz des Hybrid-Autos positioniert. Energiequelle und Wechselrichter sind ebenso wie die dieselben verbindende elektrische Leitung Wärmequellen. Sie müssen gekühlt werden, um eine unerwünschte Erwärmung des Innenraums und eine hohe Zusatzbelastung einer gegebenenfalls vorhandenen Klimaanlage zu vermeiden. Dazu ist bei dieser bekannten Kühlvorrichtung unter dem gleichen Sitz wie die erwähnten Aggregate ein Ventilator installiert. Über Luftleitkanäle wird durch den Ventilator kühle Luft von außerhalb des Hybrid-Autos angesaugt, an den erwähnten Aggregaten vorbeigeleitet und als erwärmte Luft aus dem Hybrid-Auto herausgedrückt. Diese Kühlvorrichtung ist aufwendig und durch den Ventilator oft störend laut.

Der Erfindung liegt die Aufgabe zugrunde, die eingangs geschilderte Kühlvorrichtung zu vereinfachen.

Diese Aufgabe wird gemäß der Erfindung dadurch gelöst,
- daß die Energiequelle und der Wechselrichter jeweils mit zumindest einem dieselben direkt umgebenden Kühlelement zur Führung eines fluiden Kühlmittels ausgerüstet sind und
- daß die elektrischen Leitungen mit mindestens zwei Rohren kombiniert sind, die einerseits mit den Kühlelementen von Energiequelle und Wechselrichter verbunden und andererseits zur Bildung eines Kühlmittelkreislaufs an einen Wärmetauscher angeschlossen sind.

Diese Kühlvorrichtung ist einfach aufgebaut und einfach zu montieren. Sie kann platzsparend innerhalb eines Hybrid-Autos untergebracht werden und sie arbeitet geräuschfrei und mit hohem Wirkungsgrad, weil bei ausreichender Dimensionierung die von den Wärmequellen erzeugte Wärme vollständig abgeführt werden kann. Ein besonderer Vorteil besteht darin, daß die Energiequelle und der Wechselrichter außerhalb des Innenraums des Hybrid-Autos untergebracht werden können, beispielsweise im Kofferraum oder im Motorraum desselben. Es ist auch keine konzentrierte Anordnung dieser beiden Aggregate nebeneinander erforderlich, da sie problemlos durch nahezu beliebig lange Leitungen und Rohre des Kühlmittelkreislaufs miteinander verbunden werden können.

Mit besonderem Vorteil werden die elektrischen Leiter der Leitungen und die Rohre in einem einzigen Bauteil zusammengefaßt, das dann als Einzelteil montiert werden kann. Elektrische Leiter und Rohre werden dazu zweckmäßig in einen gemeinsamen Träger aus Isoliermaterial eingebettet, der in bekannter Technik beispielsweise durch einen Extruder erzeugt werden kann. Da bei dieser Ausführungsform die elektrischen Leiter auch gekühlt werden, kann deren Querschnitt gegenüber ungekühlten Leitern verringert werden. Es werden außerdem gegebenenfalls nur wenige Durchbrüche in der Karosserie des Hybrid-Autos benötigt, weil elektrische Leiter und Rohre in einem Bauteil zusammengefaßt sind.

Die Rohre der Kühlvorrichtung können mit Vorteil an einen gegebenenfalls im Hybrid-Auto vorhandenen Kühlwasserkreislauf mit dem Kühler als Wärmetauscher angeschlossen werden. Sie können aber auch mit einem anderen Wärmetauscher (z. B. einem Klima-Kreislauf) verbunden sein.

Um Energiequelle und Wechselrichter, die dann beide nach außen feuchtigkeitsdicht abgedichtet sind, kann unter Einschluß eines Zwischenraums jeweils ein ebenfalls feuchtigkeitsdichter Mantel herumgelegt werden. Der Zwischenraum dient dann als Kühlelement, durch das ein Kühlmittel geleitet werden kann. Beide Aggregate können auch jeweils einen eigenen, als Kühlelement wirkenden Wärmetauscher haben.

Die Leitungen können als Flachleitungen oder als Rundleitungen beispielsweise mit zwei ein Kühlmittel, insbesondere Wasser, führenden Rohren ausgerüstet sein. Sie können zusätzlich mindestens einen Lichtwellenleiter aufweisen, der für die Überwachung des Ladezustands der Kondensatoren eines gegebenenfalls als Energiequelle eingesetzten Energiespeichers verwendet werden kann. Ein Lichtwellenleiter kann auch als Sensor zur Überwachung der Unversehrtheit der Leitungen selbst dienen.

Ausführungsbeispiele des Erfindungsgegenstandes sind in den Zeichnungen dargestellt.

Es zeigen:
Fig. 1 in schematischer Darstellung eine Stromversorgungseinheit für einen Elektromotor eines Hybrid-Autos.
Fig. 2 eine Ausführungsform einer in der Stromversorgungseinheit verwendbaren Energiequelle in vergrößerter Darstellung.
Fig. 3 bis 5 unterschiedliche Ausführungsformen von in der Stromversorgungseinheit verwendbaren Leitungen im Schnitt.

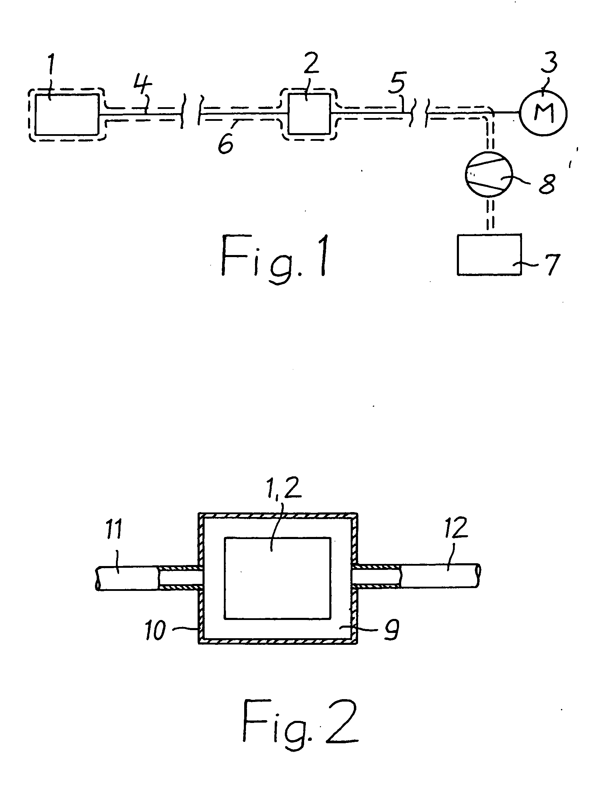

In Fig. 1 sind schematisch eine Energiequelle 1, die ein aus einer Vielzahl von Kondensatoren bestehender Energiespeicher oder eine hybridgeeignete Batterie sein kann, ein Wechselrichter 2 und ein als Drehstrommotor ausgeführter Elektromotor 3 dargestellt. Energiequelle 1 und Wechselrichter 2 sind durch eine beispielsweise zweiadrige elektrische Leitung 4 miteinander verbunden. Zwischen Wechselrichter 2 und Elektromotor 3 ist eine beispielsweise dreiadrige elektrische Leitung 5 angeschlossen. Beide Leitungen 4 und 5 sollen unabhängig von ihrem weiter unten beschriebenen Aufbau zum Schutz gegen elektromagnetische Strahlung (EMV) mit einer der Einfachheit halber nicht mit dargestellten Abschirmung versehen sein. Weitere, zur Stromversorgung des Elektromotors 3 gegebenenfalls eingesetzte Teile, beispielsweise ein Gleichstromwandler, sind der Einfachheit halber nicht mit dargestellt. Wenn solche Teile im Betrieb Wärme erzeugen, werden sie in einen weiter unten beschriebenen Kühlmittelkreislauf mit einbezogen.

Die in Fig. 1 mit eingezeichnete gestrichelte Linie soll einen Kühlmittelkreislauf 6 andeuten, der um Energiequelle 1 und Wechselrichter 2 herum sowie an den Leitungen 4 und 5 entlang geführt ist. Zum Kühlmittelkreislauf 6 gehören auch ein Wärmetauscher 7 und eine Pumpe 8, mittels derer ein fluides Kühlmittel, insbesondere Wasser, durch denselben hindurchbewegt werden kann.

Um die Aggregate Energiespeicher 1 und Wechselrichter 2 kann ein an sich beliebiges Kühlelement herum angeordnet sein, das an den Kühlmittelkreislauf 6 anschließbar ist. Das kann beispielsweise ein um diese Aggregate jeweils in Windungen herumgelegtes Rohr oder ein als Wärmetauscher ausgeführtes Bauteil sein. In bevorzugter Ausführungsform werden beide Aggregate aber nach außen feuchtigkeitsdicht abgedichtet und es wird gemäß Fig. 2 unter Einschluß eines Zwischenraums 9 ein feuchtigkeitsdichter Mantel 10 um dieselben herumgelegt. Der Zwischenraum 9 ist dann jeweils Teil des Kühlmittelkreislaufs 6, an den Rohre 11 und 12 angeschlossen werden können, so wie es in Fig. 2 angedeutet ist. Der Mantel 10 kann aus elektrisch leitfähigem Material bestehen, wie beispielsweise Kupfer oder Aluminium. Es kann aber auch ein Kunststoff eingesetzt werden, wie beispielsweise Polypropylen oder Polyethylen.

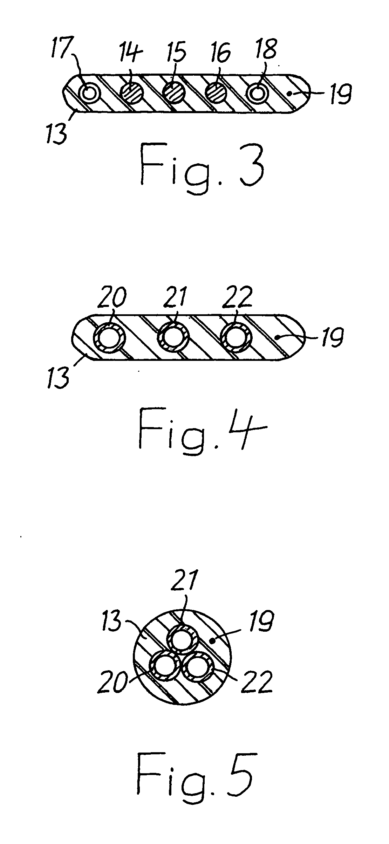

Für den Kühlmittelkreislauf 6 verwendete Rohre werden zweckmäßig mit den Leitungen 4 und 5 kombiniert. Sie können dazu beispielsweise mit fertigen Leitungen 4 und 5 zu einer Einheit zusammengefaßt werden, indem sie außen an denselben befestigt werden. Die Rohre sind aber in bevorzugter Ausführungsform als Teile der Leitungen 4 und 5 in denselben integriert. Das wird im folgenden für die Leitung 5 anhand der Fig. 3 bis 5 erläutert:

Die Leitung 5 nach Fig. 3 ist als Flachleitung ausgebildet. Sie hat drei nebeneinander in in einen gemeinsamen Träger 13 aus Isoliermaterial eingebettete elektrische Leiter 14, 15 und 16, zwei Rohre 17 und 18 und einen Lichtwellenleiter 19, die ebenfalls von dem Isoliermaterial umschlossen sind. Für den Träger 13 kann grundsätzlich jeder geeignete Kunststoff eingesetzt werden, der extrudierbar bzw. im Spritzgußverfahren verarbeitbar ist. Die Rohre 17 und 18 können aus elektrisch leitfähigem Material bestehen, wie beispielsweise Kupfer oder Aluminium. Es kann aber auch ein Kunststoff eingesetzt werden, wie beispielsweise Polypropylen oder Polyethylen. Sie sind im Kühlmittelkreislauf 6 an ihrem einen Ende mit dem Zwischenraum 9 des Wechselrichters 2 und weiterführend mit korrespondierenden Rohren in der Leitung 4 verbunden, die an den Zwischenraum 9 der Energiequelle 1 angeschlossen sind. Die Rohre 17 und 18 sind mit ihren anderen Enden mit der Pumpe 8 verbunden, durch welche das Kühlmittel durch den Kühlmittelkreislauf 6 bewegt wird. Das erwärmte Kühlmittel wird dem Wärmetauscher 7 zugeführt, von welchem die Wärme nach außen abgegeben wird. Als Wärmetauscher 7 kann mit Vorteil ein im Hybrid-Auto gegebenenfalls vorhandener Kühler verwendet werden.

Bei der Leitung 5 nach Fig. 4 sind die drei Leiter 20, 21 und 22 hohl ausgeführt, so daß sie als Rohre des Kühlmittelkreislaufs 6 das Kühlmittel selbst führen können. Gesonderte Rohre sind bei dieser Ausführungsform nicht erforderlich.

Die Elemente der Leitung 5 können abweichend von der Darstellung in den Fig. 3 und 4 auch in einer Rundleitung zusammengefaßt sein. Eine solche der Fig. 4 entsprechende Rundleitung ist in Fig. 5 dargestellt.

Der Lichtwellenleiter 19 kann an eine nicht mit dargestellte Meß- und Auswerteeinheit angeschlossen sein. Er kann für die Überwachung des Ladezustands von Kondensatoren eingesetzt werden, welche in großer Anzahl beispielsweise in einem die Energiequelle 1 bildenden Energiespeicher vorhanden sind. Der Lichtwellenleiter 19 kann auch als Sensor zur Überwachung der Leitungen 4 und 5 auf deren Unversehrtheit verwendet werden.

## Patentansprüche

1. Kühlvorrichtung eines Kraftfahrzeugs mit einem aus zwei Motoren bestehenden Antrieb, von denen einer ein Verbrennungsmotor und der andere ein über elektrische Leitungen mit einem an eine elektrische Energiequelle angeschlossenen Wechselrichter verbundener Elektromotor ist, bei welcher im Innenraum des Kraftfahrzeugs Mittel zur Kühlung der Energiequelle und des Wechselrichters angeordnet sind, **dadurch gekennzeichnet,**
- **daß** die Energiequelle (1) und der Wechselrichter (2) jeweils mit zumindest einem dieselben direkt umgebenden Kühlelement zur Führung eines fluiden Kühlmittels ausgerüstet sind und
- **daß** die elektrischen Leitungen (4,5) mit mindestens zwei Rohren (17,18) kombiniert sind, die einerseits mit den Kühlelementen von Energiequelle (1) und Wechselrichter (2) verbunden und andererseits zur Bildung eines Kühlmittelkreislaufs an einen Wärmetauscher (7) angeschlossen sind.

2. Kühlvorrichtung nach Anspruch 1, **dadurch gekennzeichnet,**
- **daß** die Energiequelle (1) und der Wechselrichter (2) nach außen feuchtigkeitsdicht abgedichtet und zur Bildung des jeweiligen Kühlelements unter Einschluß eines Zwischenraums (9) jeweils von einem feuchtigkeitsdichten Mantel (10) umgeben sind und
- **daß** die Rohre (17,18) der Leitungen (4,5) an die so gebildeten Zwischenräume (9) angeschlossen sind.

3. Kühlvorrichtung nach Anspruch 1, **dadurch gekennzeichnet, daß** Energiequelle (1) und Wechselrichter (2) jeweils mit einem an den Kühlmittelkreislauf (6) angeschlossenen Wärmetauscher ausgerüstet sind.

4. Kühlvorrichtung nach einem der Ansprüche 1 bis 3, **dadurch gekennzeichnet, daß** die elektrischen Leiter (14,15,16) der Leitungen (4,5) und die Rohre (17,18) in einen gemeinsamen Träger (13) aus lsoliermaterial eingebettet sind.

5. Kühlvorrichtung nach Anspruch 4, **dadurch gekennzeichnet, daß** Leiter (14,15,16) und Rohre (17,18) zur Bildung einer Flachleitung in einer Ebene nebeneinander angeordnet sind.

6. Kühlvorrichtung nach Anspruch 4, **dadurch gekennzeichnet, daß** Leiter (14,15,16) und Rohre (17,18) in Form einer Rundleitung zusammengefaßt sind.

7. Kühlvorrichtung nach einem der Ansprüche 4 bis 6, **dadurch gekennzeichnet, daß** die Leiter (20,21,22) hohl und damit selbst als Rohre zur Führung des Kühlmittels ausgeführt sind.

## Claims

1. Cooling apparatus for a motor vehicle having a drive which comprises two motors, of which one is an internal combustion engine and the other is an electric motor which is connected to an inverter, which is connected to an electrical energy source, via electrical cables, in which apparatus means for cooling the energy source and the inverter are arranged in the interior of the motor vehicle, **characterized in**
- **that** the energy source (1) and the inverter (2) are each equipped with at least one cooling element, which directly surrounds the said energy source or inverter, for conducting a fluid coolant, and
- **that** the electrical cables (4,5) are combined with at least two pipes (17,18) which at one end are connected to the cooling elements of the energy source (1) and inverter (2) and at the other end are connected to a heat exchanger (7) in order to form a coolant circuit.

2. Cooling apparatus according to Claim 1, **characterized in**
- **that** the energy source (1) and the inverter (2) are sealed off from the outside in a moisture-tight manner and are each surrounded by a moisture-tight casing (10) in order to form the respective cooling element with the inclusion of an intermediate space (9), and
- **that** the pipes (17,18) of the cables (4,5) are connected to the intermediate spaces (9) formed in this way.

3. Cooling apparatus according to Claim 1, **characterized in that** the energy source (1) and inverter (2) are each equipped with a heat exchanger which is connected to the coolant circuit (6).

4. Cooling apparatus according to one of the Claims 1 to 3, **characterized in that** the electrical conductors (14,15,16) of the cables (4,5) and the pipes (17,18) are embedded in a common carrier (13) which is composed of insulating material.

5. Cooling apparatus according to Claim 4, **characterized in that** the conductors (14,15,16) and pipes (17,18) are arranged in one plane in order to form a flat cable.

6. Cooling apparatus according to Claim 4, **characterized in that** conductors (14, 5,16) and pipes (17,18) are combined in the form of a round cable.

7. Cooling apparatus according to one of the Claims 4 to 6, **characterized in that** the conductors (20,21,22) are hollow elements and are therefore themselves designed as pipes for conducting the coolant.

## Revendications

1. Dispositif de refroidissement d'un véhicule automobile comprenant un entraînement constitué de deux moteurs, dont l'un est un moteur à combustion interne et l'autre un moteur électrique connecté, par le biais de conduites électriques, à un onduleur raccordé à une source d'énergie électrique, des moyens de refroidissement de la source d'énergie et de l'onduleur étant disposés dans l'habitacle du véhicule automobile, **caractérisé en ce que**
- la source d'énergie (1) et l'onduleur (2) sont équipés à chaque fois d'au moins un élément de refroidissement les entourant directement, pour guider un réfrigérant liquide, et
- les conduites électriques (4, 5) sont combinées à au moins deux tubes (17, 18) qui sont connectés d'une part aux éléments de refroidissement de la source d'énergie (1) et de l'onduleur (2) et d'autre part sont raccordés à un échangeur de chaleur (7) pour créer un circuit de réfrigérant.

2. Dispositif de refroidissement selon la revendication 1, **caractérisé en ce que**
- la source d'énergie (1) et l'onduleur (2) sont rendus étanches à l'humidité vers l'extérieur et sont entourés à chaque fois par une enveloppe (10) étanche à l'humidité pour former l'élément de refroidissement respectif en incluant un espace intermédiaire (9), et
- **en ce que** les tubes (17, 18) des conduites (4, 5) sont raccordés aux espaces intermédiaires (9) ainsi formés.

3. Dispositif de refroidissement selon la revendication 1, **caractérisé en ce que** la source d'énergie (1) et l'onduleur (2) sont équipés à chaque fois d'un échangeur de chaleur raccordé au circuit de réfrigérant (6).

4. Dispositif de refroidissement selon l'une quelconque des revendications 1 à 3, **caractérisé en ce que** les conducteurs électriques (14, 15, 16) des conduites (4, 5) et les tubes (17, 18) sont noyés dans un support commun (13) en matériau isolant.

5. Dispositif de refroidissement selon la revendication 4, **caractérisé en ce que** les conducteurs (14, 15, 16) et les tubes (17, 18) sont disposés les uns à côté des autres dans un plan pour former une conduite plate.

6. Dispositif de refroidissement selon la revendication 4, **caractérisé en ce que** les conducteurs (14, 15, 16) et les tubes (17, 18) sont rassemblés en forme de conduite ronde.

7. Dispositif de refroidissement selon l'une quelconque des revendications 4 à 6, **caractérisé en ce que** les conducteurs (20, 21, 22) sont creux et donc réalisés eux-mêmes sous forme de tubes pour guider le réfrigérant.
